# EUROPEAN PATENT APPLICATION

(11) **EP 4 468 346 A1**
(43) Date of publication of application: **27.11.2024**
(21) Application number: 24173937.4
(22) Date of filing: 02.05.2024
(51) Int. Cl.: H01L 25/075, H01L 33/50, F21Y 115/10, F21Y 113/10, F21Y 103/10

(54) **LED MODULE AND LIGHTING DEVICE**

(30) Priority: 25.05.2023 JP 2023086032
(71) Applicant: Panasonic Intellectual Property Management Co., Ltd., Osaka-shi, Osaka 571-0057 (JP)
(72) Inventor: OGATA, Toshifumi, Kadoma-shi, 571-0057 (JP); FUJITANI, Hisaki, Kadoma-shi, 571-0057 (JP); OHYA, Satoshi, Kadoma-shi, 571-0057 (JP)
(74) Representative: Müller-Boré & Partner Patentanwälte PartG mbB

(57) **Abstract**

An LED module (100) includes a substrate (1) and a plurality of LED light sources (11, .., 16) that are mounted on the substrate and include six types of LED light sources that emit light having mutually different chromaticities. In an xy chromaticity diagram in an XYZ color system defined in JIS Z8701, each of a first region (A1) in a triangular shape whose vertices are chromaticity coordinates of light emitted by three types of LED light sources (L1, L2, L3) among the six types of LED light sources and a second region (A2) in a triangular shape whose vertices are chromaticity coordinates of light emitted by other three types of LED light sources (L4, L5, L6) among the six types of LED light sources covers the entirety of white region (A0).

## Description

### Field

The present invention relates to an LED module and a lighting device.

### Background

Patent literature (PTL) 1 discloses a lighting device using a light-emitting diode (LED) module including a plurality of LED light sources that emit light having mutually different chromaticities.

### Citation List

### Patent Literature

PTL 1: Japanese Unexamined Patent Application Publication No. 2019-102396

### Summary

### Technical Problem

A lighting device for lighting effect, such as a stage light, is required to emit light with a wide color gamut. Meanwhile, when the lighting device emits light having chromaticity coordinates located within a white region in a chromaticity diagram, high total luminous flux is required.

An object of the present invention is to provide an LED module and lighting device that can emit light with a wide color gamut and can achieve high total luminous flux when emitting light having chromaticity coordinates located within a white region in a chromaticity diagram.

### Solution to Problem

A light-emitting diode (LED) module according to an aspect of the present invention includes: a substrate; and a plurality of LED light sources that are mounted on the substrate and include six types of LED light sources that emit light having mutually different chromaticities. In an xy chromaticity diagram in an XYZ color system defined in Japanese Industrial Standards (JIS) Z8701, each of a first region in a triangular shape whose vertices are chromaticity coordinates of light emitted by three types of LED light sources among the six types of LED light sources and a second region in a triangular shape whose vertices are chromaticity coordinates of light emitted by other three types of LED light sources among the six types of LED light sources covers all regions whose basic color names are white among regions defined by general chromaticity classification according to system color names in JIS Z8110.

A lighting device according to an aspect of the present invention includes the LED module.

### Advantageous Effects

According to the present invention, an LED module and lighting device that can emit light with a wide color gamut and can achieve high total luminous flux when emitting light having chromaticity coordinates located within a white region in a chromaticity diagram.

### Brief Description of Drawings

**[****FIG. 1****]**

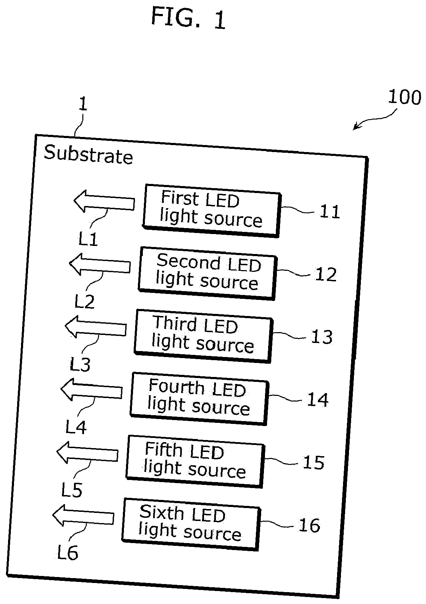

   FIG. 1 is a block diagram illustrating a configuration of an LED module according to an embodiment.
**[****FIG. 2****]**

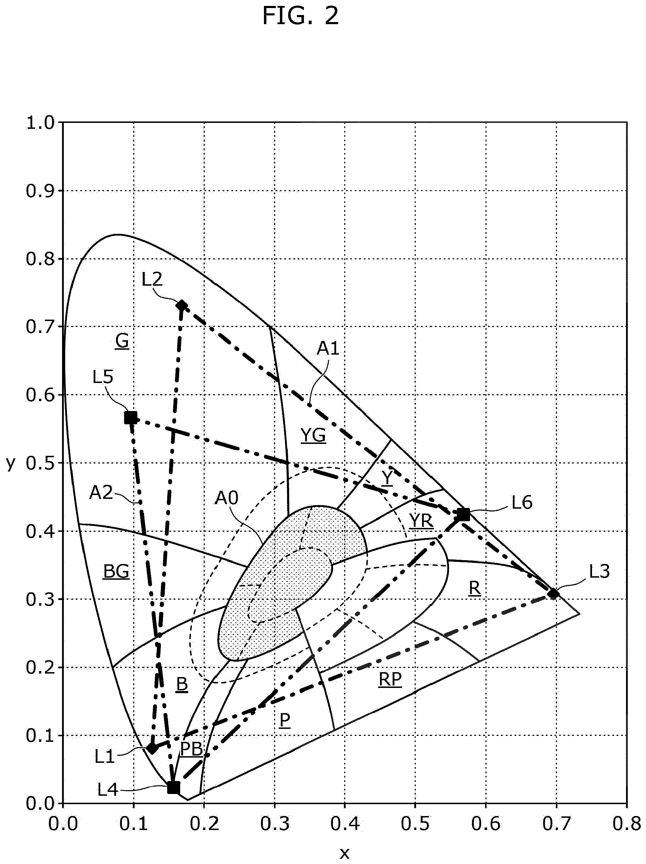

   FIG. 2 is an xy chromaticity diagram for describing an example of the chromaticities of light emitted by six types of LED light sources according to the embodiment.
**[****FIG. 3****]**

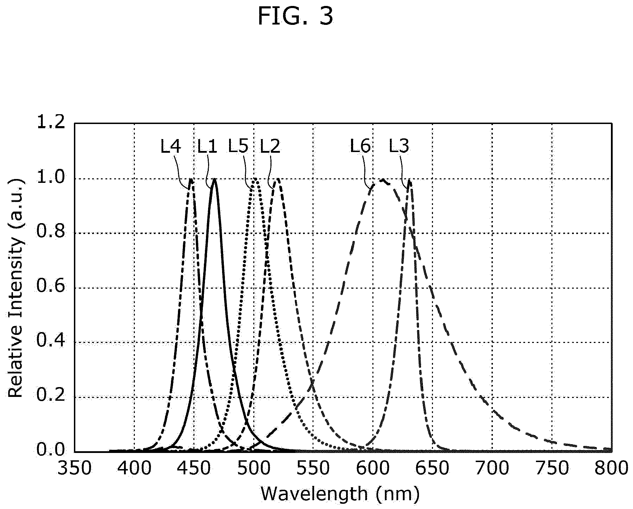

   FIG. 3 is a diagram showing an example of the spectra of light emitted by the six types of LED light sources according to the embodiment.
**[****FIG. 4****]**

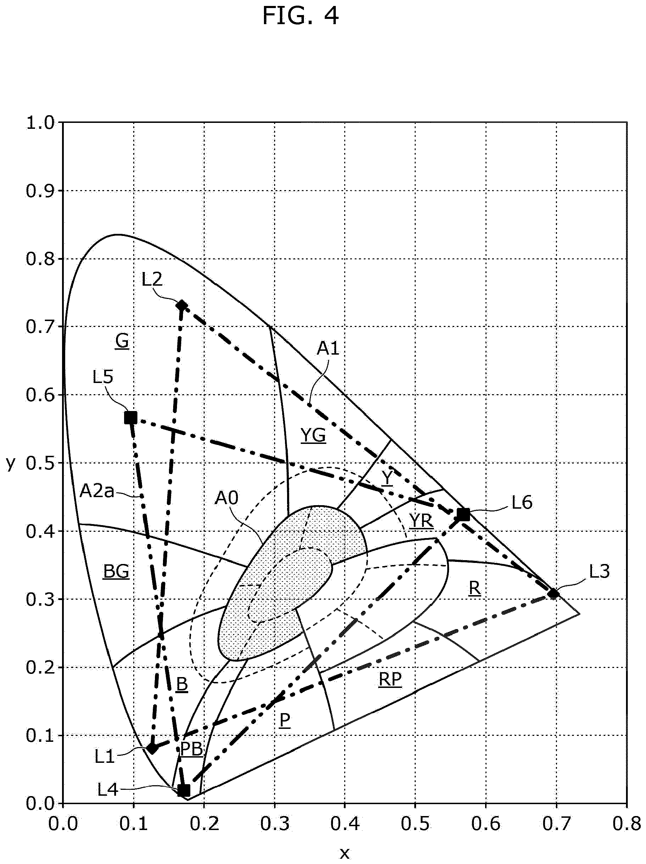

   FIG. 4 is an xy chromaticity diagram for describing another example of the chromaticities of light emitted by the six types of LED light sources according to the embodiment.
**[****FIG. 5****]**

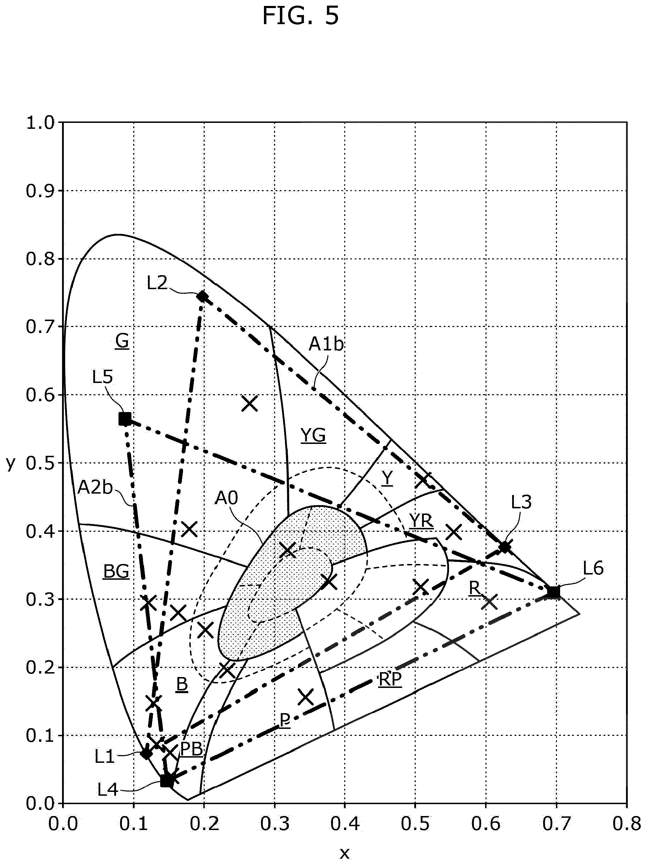

   FIG. 5 is an xy chromaticity diagram for describing still another example of the chromaticities of light emitted by the six types of LED light sources according to the embodiment.
**[****FIG. 6****]**

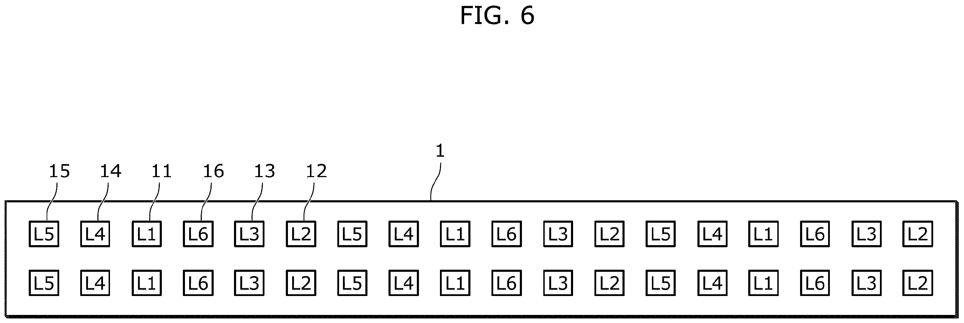

   FIG. 6 is a plan view for describing a first example of the arrangement of a plurality of LED light sources according to the embodiment.
**[****FIG. 7****]**

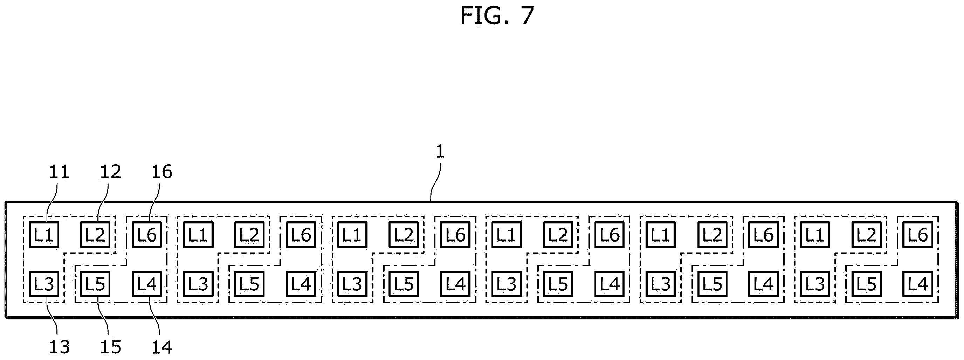

   FIG. 7 is a plan view for describing a second example of the arrangement of the plurality of LED light sources according to the embodiment.
**[****FIG. 8****]**

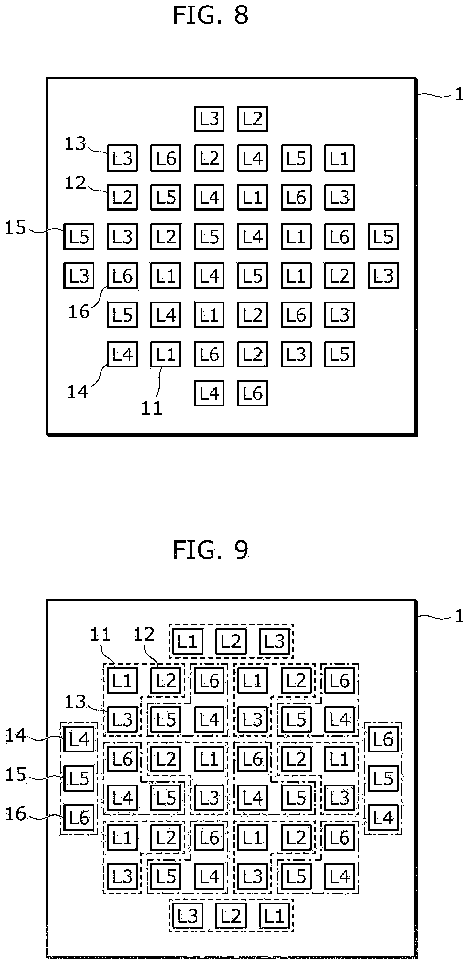

   FIG. 8 is a plan view for describing a third example of the arrangement of the plurality of LED light sources according to the embodiment.
**[****FIG. 9****]**
   FIG. 9 is a plan view for describing a fourth example of the arrangement of the plurality of LED light sources according to the embodiment.
**[****FIG. 10****]**

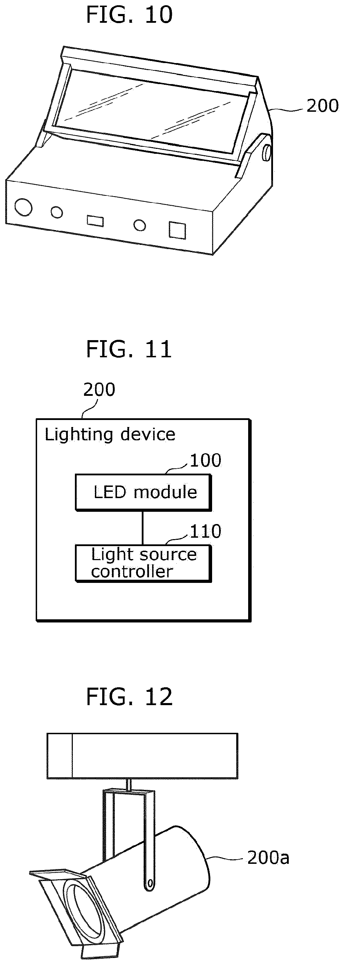

   FIG. 10 illustrates an external view of a lighting device according to the embodiment.
**[****FIG. 11****]**
   FIG. 11 is a block diagram illustrating a configuration of the lighting device according to the embodiment.
**[****FIG. 12****]**
   FIG. 12 illustrates an external view of another lighting device according to the embodiment.

### Description of Embodiment

Hereinafter, an LED module and lighting device according to an embodiment of the present invention will be described with reference to the Drawings. It should be noted that the embodiment described below shows a specific example of the present invention. Accordingly, the numerical values, shapes, materials, constituent elements, arrangement and connection of the constituent elements, steps, processing order of the steps, etc. shown in the embodiment below are mere examples, and therefore do not limit the scope of the present invention. Among the constituent elements in the embodiment below, constituent elements not recited in any one of the independent claims are described as arbitrary constituent elements.

Moreover, the respective Drawings are schematic diagrams and are not necessarily precise illustrations. Accordingly, for example, the scaling, etc., depicted in the Drawings is not necessarily accurate. Moreover, in the Drawings, elements having essentially the same configuration share like reference signs and overlapping descriptions thereof may be omitted or simplified.

Furthermore, in the Specification, a term indicating a relationship between elements, a term indicating the shape of an element, and a numerical range are not intended to represent the exact meaning thereof, and may include a deviation of a few percent, for example.

Furthermore, in the Specification, ordinal numbers, such as "first" and "second", do not mean the number or order of constituent elements unless otherwise specified, and are used for the purpose of avoiding confusion of constituent elements of the same type and differentiating them.

Furthermore, in the Specification, "chromaticity coordinates" are xy chromaticity coordinates in an XYZ color system defined in JIS Z8701.

### Embodiment

### [LED module]

First, a configuration of an LED module according to Embodiment 1 is described with reference to FIG. 1.

FIG. 1 is a block diagram illustrating a configuration of LED module 100 according to the present embodiment.

As illustrated in FIG. 1, LED module 100 includes substrate 1 and, as six types of LED light sources that emit light having mutually different chromaticities, a plurality of LED light sources including first LED light source 11, second LED light source 12, third LED light source 13, fourth LED light source 14, fifth LED light source 15, and sixth LED light source 16. In LED module 100, light emissions from LED light sources supplied with power, among the plurality of LED light sources, are mixed and outputted. First LED light source 11 emits first light L1. Second LED light source 12 emits second light L2. Third LED light source 13 emits third light L3. Fourth LED light source 14 emits fourth light L4. Fifth LED light source 15 emits fifth light L5. Sixth LED light source 16 emits sixth light L6.

Each of the plurality of LED light sources is, for example, a Surface Mount Device (SMD) LED light source or a Chip On Board (COB) LED light source.

Substrate 1 is a mounting substrate for mounting the plurality of LED light sources. Substrate 1 is provided with metal wiring for supplying power to each of first LED light source 11, second LED light source 12, third LED light source 13, fourth LED light source 14, fifth LED light source 15, and sixth LED light source 16.

Substrate 1 is, for example, an insulating substrate such as a ceramic substrate made of ceramics, resin substrate made of resin, or glass substrate. Alternatively, substrate 1 may be a metal base substrate (metal substrate) that is a metal plate covered with an insulating film.

Each of the plurality of LED light sources includes at least an LED chip. The LED chip may be sealed by a sealing material. Although each of the plurality of LED light sources includes a single LED chip for example, each of the plurality of LED light sources may include a plurality of LED chips that emit light in the same color. Moreover, at least one of the six types of LED light sources may further include a phosphor that is dispersed in the sealing material and emits light when excited by light emitted by the LED chip. Since the phosphor has an emission peak which is broader than that of the LED chip, the wavelength range of the spectrum of light emitted by the LED light source becomes wide, and thus a color rendering property can be enhanced.

The type of an LED chip and the type of a phosphor used in each of the plurality of LED light sources are not particularly limited as long as the plurality of LED light sources can emit light having chromaticities to be described later. For example, when an LED light source emits red light, an InGaAs LED chip is used as the LED chip. Moreover, for example, when an LED light source emits yellow-red, yellow, yellow-green, green, blue-green, blue, purple-blue, purple, or red-purple light, a GaN LED chip is used as the LED chip. Furthermore, for example, an yttrium aluminum garnet (YAG) phosphor, lutetium aluminum garnet (LuAG) phosphor, β-sialon phosphor, nitride phosphor (CASN phosphor or SCASN phosphor), or the like is used as the phosphor. Each of the plurality of LED light sources that emit light having chromaticities to be described later can be realized by appropriately selecting the type of the phosphor according to the type of the LED chip as needed. It should be noted that the color of light emitted by each of the plurality of LED light sources is a color defined based on the general chromaticity classification according to the system color names in JIS Z8110.

When an SMD LED light source is used, a package housing an LED chip as an LED light source is mounted on substrate 1. Moreover, when a COB LED light source is used, an LED chip as an LED light source is directly mounted on substrate 1.

Although the number of each type of the six types of LED light sources mounted on substrate 1 is, for example, two or more, the number of each type of the six types of LED light sources mounted on substrate 1 may be one. Moreover, although the number of each type of the six types of LED light sources mounted on substrate 1 is, for example, the same as one another, the number of each type of the six types of LED light sources mounted on substrate 1 may be different from one another.

Here, the chromaticities of light emitted by the six types of LED light sources are described with reference to FIG. 2. FIG. 2 is an xy chromaticity diagram for describing an example of the chromaticities of light emitted by the six types of LED light sources according to the present embodiment. In FIG. 2, xy chromaticity coordinates in an XYZ color system defined in JIS Z8701 are shown. The specific chromaticity coordinates of light (first light L1, second light L2, third light L3, fourth light L4, fifth light L5, and sixth light L6) emitted by the six types of LED light sources in FIG. 2 are shown in the following Table 1.

**[Table 1]**

| Light | x | y |
|---|---|---|
| L1 | 0.126 | 0.078 |
| L2 | 0.168 | 0.729 |
| L3 | 0.695 | 0.305 |
| L4 | 0.157 | 0.021 |
| L5 | 0.095 | 0.565 |
| L6 | 0.568 | 0.422 |

Moreover, in FIG. 2, regions defined by the general chromaticity classification according to the system color names in JIS Z8110 are shown together with the chromaticity coordinates of light emitted by the six types of LED light sources. Furthermore, in FIG. 2, regions represented by R, YR, Y, YG, G, BG, B, PB, P, and RP each of which is enclosed by a solid line or a solid line and a broken line are a red region, a yellow-red region, a yellow region, a yellow-green region, a green region, a blue-green region, a blue region, a purple-blue region, a purple region, and a red-purple region, respectively. The same is applied to the other xy chromaticity diagrams subsequent to FIG. 2. Moreover, in the Specification, a color of light corresponds to any one of the regions defined by solid and broken lines illustrated in FIG. 2 and so on. In other words, when a color of light corresponds to a region of a color named by adding a modifier to a basic color name, the color of light is different from a color of light corresponding to a region of the basic color name, among the regions defined by the solid and broken lines.

As illustrated in FIG. 2, each of first region A1 in a triangular shape whose vertices are chromaticity coordinates of light emitted by three types of LED light sources among the six types of LED light sources and second region A2 in a triangular shape whose vertices are chromaticity coordinates of light emitted by other three types of LED light sources among the six types of LED light sources covers the entirety of white region A0 consisting of regions whose basic color names are white among the regions defined by the general chromaticity classification according to the system color names in JIS Z8110. In FIG. 2, white region A0 is a region hatched with dots, first region A1 is a region enclosed by a dashed single-dotted line, and second region A2 is a region enclosed by a dashed double-dotted line. Moreover, in the present embodiment, the three types of LED light sources corresponding to first region A1 are first LED light source 11, second LED light source 12, and third LED light source 13. Furthermore, the other three types of LED light sources corresponding to second region A2 are fourth LED light source 14, fifth LED light source 15, and sixth LED light source 16. Accordingly, first region A1 is in a triangular shape whose vertices are the chromaticity coordinates of first light L1, second light L2, and third light L3. Moreover, second region A2 is in a triangular shape whose vertices are the chromaticity coordinates of fourth light L4, fifth light L5, and sixth light L6.

Furthermore, each set of the chromaticity coordinates of light emitted by the six types of LED light sources is, for example, located in a corresponding one of outermost regions among the regions defined by the general chromaticity classification according to the system color names in JIS Z8110. In other words, each color of first light L1, second light L2, third light L3, fourth light L4, fifth light L5, and sixth light L6 is a color from among red, yellow-red, yellow, yellow-green, green, blue-green, blue, purple-blue, purple, and red-purple. Thus, the color gamut of light emitted by LED module 100 can be widened.

In the example illustrated in FIG. 2, the colors of first light L1, second light L2, third light L3, fourth light L4, fifth light L5, and sixth light L6 are blue, green, red, purple-blue, green, and yellow-red, respectively. Accordingly, at least one set of the chromaticity coordinates of light emitted by the six types of LED light sources is located in each of the red region, the green region, the blue region, the yellow-red region, and the purple-blue region, among the regions defined by the general chromaticity classification according to the system color names in JIS Z8110. Thus, the color gamut of light emitted by LED module 100 can be widened. Moreover, since the chromaticity coordinates of light emitted by the six types of LED light sources are located in regions of five colors, the six types of LED light sources can emit light in the five colors and can enhance a color rendering property when LED module 100 emits light having chromaticity coordinates located within white region A0.

The color of each of second light L2 and fifth light L5 is green. When the green region is divided into a region whose color is close to yellow-green rather than blue-green and a region whose color is close to blue-green rather than yellow-green, the chromaticity coordinates of second light L2 is located in the region whose color is close to yellow-green rather than blue-green and the chromaticity coordinates of fifth light L5 is located in the region whose color is close to blue-green rather than yellow-green.

FIG. 3 is a diagram showing an example of the spectra of light emitted by the six types of LED light sources according to the present embodiment. In FIG. 3, the horizontal axis represents wavelength (unit: nm). Moreover, in FIG. 3, the vertical axis represents light emission intensity standardized by scaling the maximum value of the light emission intensity to 1.

In the example illustrated in FIG. 3, the spectra of first light L1, second light L2, third light L3, fourth light L4, and fifth light L5 have relatively sharp emission peaks. Each of those relatively sharp emission peaks is derived from light emitted by an LED chip. In other words, each of first LED light source 11, second LED light source 12, third LED light source 13, fourth LED light source 14, and fifth LED light source 15 does not include a phosphor and emits light emitted by an LED chip only. In contrast, the spectrum of sixth light L6 has a broad emission peak. This broad emission peak is derived from light emitted by a phosphor. In other words, sixth LED light source 16 includes an LED chip and a phosphor and emits light emitted mainly by the phosphor. For example, the percentage of the radiant flux of light emitted by the phosphor in the total radiant flux of sixth light L6 is 90 % or more. In the example illustrated in FIG. 3, since the color of sixth light L6 is yellow-red, sixth LED light source 16 includes a phosphor that emits yellow-red light. Thus, since sixth LED light source 16 that emits yellow-red sixth light L6 includes a phosphor, sixth light L6 has a broader emission peak as compared to the case without a phosphor. Consequently, sixth light L6 has a larger amount of components each having a wavelength of around 555 nm and high spectral luminous efficiency as compared to the case without a phosphor, and thus total luminous flux can be increased.

It should be noted that sixth LED light source 16 does not necessarily include a phosphor. Moreover, an LED light source other than sixth LED light source 16 may include a phosphor. For example, at least one of second LED light source 12 that emits green second light L2 or fifth LED light source 15 that emits green fifth light L5 may include a phosphor. Accordingly, at least one of second light L2 or fifth light L5 can have a larger amount of components each having a wavelength of around 555 nm and high spectral luminous efficiency as compared to the case without a phosphor, and thus total luminous flux can be increased.

### [Advantageous Effects]

As described above, LED module 100 according to the present embodiment includes substrate 1 and a plurality of LED light sources that are mounted on substrate 1 and include six types of LED light sources that emit light having mutually different chromaticities. Each of first region A1 in a triangular shape whose vertices are chromaticity coordinates of light emitted by three types of LED light sources among the six types of LED light sources and second region A2 in a triangular shape whose vertices are chromaticity coordinates of light emitted by other three types of LED light sources among the six types of LED light sources covers the entirety of white region A0 consisting of regions whose basic color names are white among regions defined by general chromaticity classification according to system color names in JIS Z8110. Specifically, the six types of LED light sources are first LED light source 11, second LED light source 12, third LED light source 13, fourth LED light source 14, fifth LED light source 15, and sixth LED light source 16. Moreover, the three types of LED light sources are first LED light source 11, second LED light source 12, and third LED light source 13. Furthermore, the other three types of LED light sources are fourth LED light source 14, fifth LED light source 15, and sixth LED light source 16.

Accordingly, LED module 100 can emit light with a wide color gamut by the six types of LED light sources including the three types of LED light sources and the other three types of LED light sources that can achieve any chromaticity coordinates of light within a wide region covering the entirety of white region A0. Moreover, if the number of types of LED light sources that emit light having different chromaticities is merely increased for widening a color gamut, an LED light source that is unlikely to contribute to the total luminous flux is likely to exist when LED module 100 emit light having chromaticity coordinates located within white region A0, a chromaticity shift from a desired chromaticity is likely to occur when all of the LED light sources are turned on, and complicated control is required for reducing such a chromaticity shift. In the present embodiment, since each of first region A1 and second region A2 covers the entirety of white region A0, light having chromaticity coordinates located within white region A0 can be achieved while the three types of LED light sources ant the other three types of LED light sources are turned on, and high total luminous flux can be achieved when LED module 100 emits light having chromaticity coordinates located within white region A0. Moreover, since light having chromaticity coordinates located within white region A0 can be achieved by the three types of LED light sources corresponding to first region A1 as well as by the other three types of LED light sources corresponding to second region A2, a chromaticity shift can be easily adjusted.

Furthermore, in LED module 100, since light with a wide color gamut as described above can be achieved by two control systems which are a control system of the three types of LED light sources and a control system of the other three types of LED light sources, the design of a control circuit can be made easy.

### [Other Examples of Chromaticities of Light Emitted by LED Light Sources]

In LED module 100, the chromaticities of light emitted by the six types of LED light sources are not limited to the example illustrated in FIG. 2, and not particularly limited as long as the chromaticities are set so that each of the above described first region and second region covers the entirety of white region A0. Hereinafter, other examples of the chromaticities of light emitted by the six types of LED light sources are described. The chromaticities of light emitted by the six types of LED light sources are not limited to the example described above and the examples to be described below.

FIG. 4 is an xy chromaticity diagram for describing another example of the chromaticities of light emitted by the six types of LED light sources according to the present embodiment. The specific chromaticity coordinates of light (first light L1, second light L2, third light L3, fourth light L4, fifth light L5, and sixth light L6) emitted by the six types of LED light sources in FIG. 4 are shown in the following Table 2.

**[Table 2]**

| Light | x | y |
|---|---|---|
| L1 | 0.126 | 0.078 |
| L2 | 0.168 | 0.729 |
| L3 | 0.695 | 0.305 |
| L4 | 0.171 | 0.016 |
| L5 | 0.095 | 0.565 |
| L6 | 0.568 | 0.422 |

In the example illustrated in FIG. 4, the chromaticity coordinates of fourth light L4 are different from that in the example illustrated in FIG. 2, and second region A2a in a triangular shape whose vertices are the chromaticity coordinates of fourth light L4, fifth light L5, and sixth light L6 covers the entirety of white region A0. In the example illustrated in FIG. 4, although the color of fourth light L4 is purple-blue similar to the example illustrated in FIG. 2, the color of fourth light L4 is purple-blue which is closer to purple compared to that in the example illustrated in FIG. 2. It should be noted that the color of fourth light L4 may be purple. In this case, at least one set of the chromaticity coordinates of light emitted by the six types of LED light sources is located in each of the red region, the green region, the blue region, the yellow-red region, and the purple region, among the regions defined by general chromaticity classification according to the system color names in JIS Z8110.

Moreover, FIG. 5 is an xy chromaticity diagram for describing still another example of the chromaticities of light emitted by the six types of LED light sources according to the present embodiment. The specific chromaticity coordinates of light (first light L1, second light L2, third light L3, fourth light L4, fifth light L5, and sixth light L6) emitted by the six types of LED light sources in FIG. 5 are shown in the following Table 3.

**[Table 3]**

| Light | x | y |
|---|---|---|
| L1 | 0.120 | 0.070 |
| L2 | 0.200 | 0.740 |
| L3 | 0.6275 | 0.3716 |
| L4 | 0.149 | 0.029 |
| L5 | 0.090 | 0.560 |
| L6 | 0.695 | 0.305 |

Moreover, in FIG. 5, each set of the chromaticity coordinates of the 19 colors of POLY COLOUR color filters defined by Japan Association of Theatre and Entertainment Technology is indicated by the symbol "X", in addition to the chromaticity coordinates of light emitted by the six types of LED light sources. The specific chromaticity coordinates of the 19 colors of POLY COLOUR color filters are shown in the following Table 4. In Table 4, filter No. is the number of a color filter applied to a halogen lamp or the like used for stage lighting.

**[Table 4]**

| Filter No. | x | y |
|---|---|---|
| 140 | 0.6061 | 0.2913 |
| 16 | 0.5086 | 0.3141 |
| 22 | 0.6946 | 0.3047 |
| 31 | 0.6275 | 0.3716 |
| 38 | 0.555 | 0.3939 |
| 40 | 0.5126 | 0.4701 |
| 57 | 0.1805 | 0.398 |
| 59 | 0.2666 | 0.5825 |
| 63 | 0.1225 | 0.2907 |
| 64 | 0.3194 | 0.3679 |
| 65 | 0.1656 | 0.2755 |
| 71 | 0.1547 | 0.0373 |
| 72 | 0.1354 | 0.0825 |
| 77 | 0.1303 | 0.1439 |
| 78 | 0.2041 | 0.2503 |
| 84 | 0.3459 | 0.1524 |
| 86 | 0.1538 | 0.0704 |
| 87 | 0.2344 | 0.191 |
| 88 | 0.3788 | 0.3222 |

In the example illustrated in FIG. 5, the chromaticities of light emitted by the six types of LED light sources are different from that in the example illustrated in FIG. 2, and the colors of first light L1, second light L2, third light L3, fourth light L4, fifth light L5, and sixth light L6 in the example illustrated in FIG. 5 are blue, green, yellow-red, blue, green, and red, respectively. Accordingly, at least one set of the chromaticity coordinates of light emitted by the six types of LED light sources is located in each of the red region, the green region, the blue region, and the yellow-red region, among the regions defined by the general chromaticity classification according to the system color names in JIS Z8110. Thus, the color gamut of light emitted by LED module 100 can be widened. Moreover, since the chromaticity coordinates of light emitted by the six types of LED light sources are located in regions of four colors, the six types of LED light sources can emit light in the four colors and can enhance a color rendering property when LED module 100 emits light having chromaticity coordinates located within white region A0.

In the example illustrated in FIG. 5, each of first region A1b in a triangular shape whose vertices are the chromaticity coordinates of first light L1, second light L2, and third light L3, and second region A2b in a triangular shape whose vertices are the chromaticity coordinates of fourth light L4, fifth light L5, and sixth light L6 covers the entirety of white region A0.

Moreover, each set of the chromaticity coordinates of the 19 colors of POLY COLOUR color filters defined by Japan Association of Theatre and Entertainment Technology is covered by at least one of first region A1b or second region A2b. Thus, the 19 colors of POLY COLOUR color filters can be achieved by controlling one of the amount of light from first LED light source 11, second LED light source 12, and third LED light source 13 or the amount of light from fourth LED light source 14, fifth LED light source 15, and sixth LED light source 16. Accordingly, in a lighting effect using LED module 100, light having a wide color gamut can be achieved and control of LED module 100 can be simplified.

### [Examples of Arrangement of LED Light Sources]

Next, examples of the arrangement of the plurality of LED light sources mounted on substrate 1 are described. It should be noted that the shape of substrate 1 and the arrangement of the plurality of LED light sources described below are mere examples and not limited to the examples below.

FIG. 6 is a plan view for describing a first example of the arrangement of the plurality of LED light sources according to the present embodiment. FIG. 7 is a plan view for describing a second example of the arrangement of the plurality of LED light sources according to the present embodiment. FIG. 8 is a plan view for describing a third example of the arrangement of the plurality of LED light sources according to the present embodiment. FIG. 9 is a plan view for describing a fourth example of the arrangement of the plurality of LED light sources according to the present embodiment. In FIG. 6 to FIG. 9, each LED light source is schematically illustrated as a rectangle in a plan view of substrate 1, and a reference sign in each rectangle representing an LED light source indicates light emitted from the LED light source.

As illustrated in FIG. 6 to FIG. 9, plural sets of the six types of LED light sources are mounted on substrate 1. Although not illustrated in the Drawings, LED light sources of the same type are, for example, electrically connected in series by wiring, cable, or the like.

First, examples of the arrangement of the plurality of LED light sources where substrate 1 is in an elongated shape as illustrated in FIG. 6 and FIG. 7 are described. In the Specification, "elongated" means that the length in a lengthwise direction is three times or more longer than the length in a crosswise direction. It should be noted that, although the plan view shape of substrate 1 is an elongated rectangle in the examples illustrated in FIG. 6 and FIG. 7, the plan view shape of substrate 1 may be any shape other than rectangle.

In each of the examples illustrated in FIG. 6 and FIG. 7, the plurality of LED light sources are mounted on substrate 1 such that the plurality of LED light sources are arranged in two rows along the lengthwise direction of substrate 1. Since the plurality of LED light sources are arranged along the lengthwise direction of substrate 1, light can be widely emitted in the lengthwise direction of substrate 1, and since the plurality of LED light sources are arranged in two rows, occurrence of color unevenness can be suppressed. It should be noted that the number of rows in which the plurality of LED light sources are arranged is not limited to two, and may be one or three. Moreover, the number of rows in which the plurality of LED light sources are arranged may be four or more, depending on the size of substrate 1.

In the example illustrated in FIG. 6, the plurality of LED light sources are mounted on substrate 1 such that the six types of LED light sources are arranged in the same order repeatedly along the lengthwise direction of substrate 1. Moreover, the arrangement order of LED light sources in one of the two rows is the same as that in the other of the two rows.

Furthermore, FIG. 6 shows the example of the arrangement of the plurality of LED light sources where the six types of LED light sources emit light having the chromaticities in the example illustrated in FIG. 2 or FIG. 4. Therefore, first LED light source 11 is a blue LED light source that emits blue first light L1, fourth LED light source 14 is a purple-blue LED light source that emits purple-blue fourth light L4, and third LED light source 13 is a red LED light source that emits red third light L3. Third LED light source 13 that is the red LED light source is likely to absorb light having a short wavelength, and a photoelectric effect is likely to occur. In the example illustrated in FIG. 6, third LED light source 13 is mounted on substrate 1 such that third LED light source 13 is not placed next to each of first LED light source 11 that is the blue LED light source and fourth LED light source 14 that is the purple-blue LED light source. Therefore, occurrence of a photoelectric effect in third LED light source 13 can be suppressed and a chromaticity shift and unintentional occurrence of voltage in third LED light source 13 can also be suppressed. In the Specification, being placed next to something means that being placed next to something in a direction in which the plurality of LED light sources are arranged (direction in which the plurality of LED light sources are aligned), such as a column direction, row direction, etc. when the plurality of LED light sources are arranged in a matrix.

It should be noted that even when a purple LED light source that emits purple light is included in the six types of LED light sources, the above-described effect can be achieved by arranging the plurality of LED light sources on substrate 1 such that a red LED light source is not placed next to the purple LED light source. In other words, the above-described effect can be achieved by arranging the plurality of LED light sources on substrate 1 such that a red LED light source is not placed next to an LED light source that emits light having a wavelength shorter than or equal to a wavelength of blue.

Moreover, FIG. 7 shows the example of the arrangement of the plurality of LED light sources where the six types of LED light sources emit light having the chromaticities in the example illustrated in FIG. 2, FIG. 4, or FIG. 5. In the example illustrated in FIG. 7, the plurality of LED light sources are mounted on substrate 1 such that one of three LED light sources that are first LED light source 11, second LED light source 12, and third LED light source 13 is placed next to each of other two of the three LED light sources, among the plurality of LED light sources. Moreover, the plurality of LED light sources are mounted on substrate 1 such that one of three LED light sources that are fourth LED light source 14, fifth LED light source 15, and sixth LED light source 16 is placed next to each of other two of the three LED light sources, among the plurality of LED light sources. Thus, first LED light source 11, second LED light source 12, and third LED light source 13 are arranged adjacent to one another as a combination that can achieve light having chromaticity coordinates located within white region A0 by mixing light emitted therefrom, and fourth LED light source 14, fifth LED light source 15, and sixth LED light source 16 are arranged adjacent to one another as a combination that can achieve light having chromaticity coordinates located within white region A0 by mixing light emitted therefrom. Therefore, color unevenness can be reduced when LED module 100 emits light having chromaticity coordinates located within white region A0. In FIG. 7, the combination of first LED light source 11, second LED light source 12, and third LED light source 13 is enclosed by a broken line, and the combination of fourth LED light source 14, fifth LED light source 15, and sixth LED light source 16 is enclosed by a dashed single-dotted line. The same applies to FIG. 9.

Moreover, although each of the combination of first LED light source 11, second LED light source 12, and third LED light source 13 and the combination of fourth LED light source 14, fifth LED light source 15, and sixth LED light source 16 is in the L shape in the example illustrated in FIG. 7, each of the combinations may be in the I shape.

Furthermore, in the example illustrated in FIG. 7, first LED light source 11 and third LED light source 13 are mounted on one end of substrate 1 in the lengthwise direction of substrate 1. Furthermore, fourth LED light source 14 and sixth LED light source 16 are mounted on the other end of substrate 1 in the lengthwise direction of substrate 1. The LED light sources mounted on the one end of substrate 1 in the lengthwise direction of substrate 1 are LED light sources placed on one end in a direction in which the plurality of LED light sources are arranged, among the plurality of LED light sources arranged in the lengthwise direction of substrate 1. Similarly, the LED light sources mounted on the other end of substrate 1 in the lengthwise direction of substrate 1 are LED light sources placed on the other end in the direction in which the plurality of LED light sources are arranged, among the plurality of LED light sources arranged in the lengthwise direction of substrate 1.

Fourth LED light source 14 mounted on the other end of substrate 1 is an LED light source that emits fourth light L4 having chromaticity coordinates closest to the chromaticity coordinates of first light L1 emitted by first LED light source 11 mounted on the one end of substrate 1, among fourth LED light source 14, fifth LED light source 15, and sixth LED light source 16. Moreover, sixth LED light source 16 mounted on the other end of substrate 1 is an LED light source that emits sixth light L6 having chromaticity coordinates closest to the chromaticity coordinates of third light L3 emitted by third LED light source 13 mounted on the one end of substrate 1, among fourth LED light source 14, fifth LED light source 15, and sixth LED light source 16. Although chromaticity unevenness is likely to occur in light emitted from around both ends of substrate 1 when substrate 1 in an elongated shape is used, chromaticity difference between light emitted from around the one end of substrate 1 and light emitted from around the other end of substrate 1 can be reduced by the above-described arrangement. It should be noted that the same type of LED light sources may be mounted on the both ends of substrate 1 in the lengthwise direction of substrate 1. The above-described effect can also be achieved by this.

Moreover, in the example illustrated in FIG. 7, the plurality of LED light sources are mounted on substrate 1 such that the combination of first LED light source 11, second LED light source 12, and third LED light source 13 and the combination of fourth LED light source 14, fifth LED light source 15, and sixth LED light source 16 are alternately arranged along the lengthwise direction of substrate 1.

It should be noted that an arrangement made by combining the feature of the arrangement of the plurality of LED light sources in the example illustrated in FIG. 6 and the feature of the arrangement of the plurality of LED light sources in the example illustrated in FIG. 7 can be realized by adjusting the arrangement of the plurality of LED light sources and the colors of light emitted by the six types of LED light sources.

Next, examples of the arrangement of the plurality of LED light sources where substrate 1 is in a square shape as illustrated in FIG. 8 and FIG. 9 are described.

In each of the examples illustrated in FIG. 8 and FIG. 9, the plurality of LED light sources are arranged in a matrix and mounted on substrate 1, and the number of LED light sources arranged at each end of substrate 1 in a row direction or a column direction is smaller than the number of LED light sources arranged at a middle part of substrate 1.

In FIG. 8, an example of the arrangement of the plurality of LED light sources where the six types of LED light sources emit light having the chromaticities in the example illustrated in FIG. 2 or FIG. 4 is described. In the example illustrated in FIG. 8, similar to the example illustrated in FIG. 6, third LED light source 13 is mounted on substrate 1 such that third LED light source 13 is not placed next to each of first LED light source 11 and fourth LED light source 14. Therefore, occurrence of a photoelectric effect in third LED light source 13 can be suppressed and a chromaticity shift and unintentional occurrence of voltage in third LED light source 13 can also be suppressed.

Moreover, in FIG. 9, an example of the arrangement of the plurality of LED light sources where the six types of LED light sources emit light having the chromaticities in the example illustrated in FIG. 2, FIG. 4, or FIG. 5 is described. In the example illustrated in FIG. 9, similar to the example illustrated in FIG. 7, the plurality of LED light sources are mounted on substrate 1 such that one of three LED light sources that are first LED light source 11, second LED light source 12, and third LED light source 13 is placed next to each of other two of the three LED light sources, among the plurality of LED light sources. Moreover, the plurality of LED light sources are mounted on substrate 1 such that one of three LED light sources that are fourth LED light source 14, fifth LED light source 15, and sixth LED light source 16 is placed next to each of other two of the three LED light sources, among the plurality of LED light sources. Thus, color unevenness can be reduced when LED module 100 emits light having chromaticity coordinates located within white region A0.

It should be noted that an arrangement made by combining the feature of the arrangement of the plurality of LED light sources in the example illustrated in FIG. 8 and the feature of the arrangement of the plurality of LED light sources in the example illustrated in FIG. 9 can be realized by adjusting the arrangement of the plurality of LED light sources and the colors of light emitted by the six types of LED light sources.

### [Lighting Device]

Next, a lighting device including LED module 100 according to the present embodiment is described.

FIG. 10 illustrates an external view of lighting device 200 according to the present embodiment. FIG. 11 is a block diagram illustrating a configuration of lighting device 200 according to the present embodiment.

Lighting device 200 according to the present embodiment is a stage lighting device used for lighting effect, for example. Specifically, as illustrated in FIG. 10, lighting device 200 is a cyclorama light that irradiates a cyclorama with light. Although lighting device 200 is a ground cyclorama light that irradiates a cyclorama with light from the bottom in the example illustrated in FIG. 10, lighting device 200 may be an overhead cyclorama light that irradiates a cyclorama with light from the above.

As illustrated in FIG. 11, lighting device 200 includes LED module 100 and light source controller 110. LED module 100 and light source controller 110 are, for example, housed in a housing of lighting device 200. Lighting device 200 emits, as illumination light, light emitted by LED module 100. When lighting device 200 is a cyclorama light, LED module 100 including substrate 1 in an elongated shape as illustrated in FIG. 6 and FIG. 7 is used, for example. Lighting device 200 may include a plurality of LED modules 100.

Light source controller 110 is a control circuit that controls light emission of each of LED light sources of LED module 100. Accordingly, light source controller 110 performs dimming and color control of illumination light. For example, light source controller 110 obtains a control signal from the outside and controls light emission of each of the LED light sources of LED module 100 based on the control signal obtained. For example, light source controller 110 adjusts the amount of each of first light L1, second light L2, third light L3, fourth light L4, fifth light L5, and sixth light L6, by adjusting the amount of current supplied to each of first LED light source 11, second LED light source 12, third LED light source 13, fourth LED light source 14, fifth LED light source 15, and sixth LED light source 16.

For example, light source controller 110 includes a control system that adjusts the amount of current supplied to first LED light source 11, second LED light source 12, and third LED light source 13 and a control system that adjusts the amount of current supplied to fourth LED light source 14, fifth LED light source 15, and sixth LED light source 16. For example, light source controller 110 performs color control of illumination light within a range of first region A1 or A1b, by controlling the ratio of current supplied to first LED light source 11, second LED light source 12, and third LED light source 13. Moreover, for example, light source controller 110 performs color control of illumination light within a range of second region A2, A2a, or A2b, by controlling the ratio of current supplied to fourth LED light source 14, fifth LED light source 15, and sixth LED light source 16.

Furthermore, when LED module 100 emits illumination light having chromaticity coordinates located within white region A0, light source controller 110 supplies current to each of first LED light source 11, second LED light source 12, third LED light source 13, fourth LED light source 14, fifth LED light source 15, and sixth LED light source 16 to cause them to emit light.

For example, light source controller 110 includes a power supply circuit that converts alternating current supplied from a commercial power supply into direct current and a current control circuit that adjusts the amount of current supplied to LED module 100. Light source controller 110 may further include memory and a processor.

It should be noted that the type of a lighting device according to the present embodiment is not limited to a cyclorama light and an example of the lighting device is not particularly limited. For example, a lighting device according to the present embodiment may be a spotlight, downlight, ceiling light, or the like. FIG. 12 illustrates an external view of another lighting device 200a according to the present embodiment. As illustrated in FIG. 12, lighting device 200a is a spotlight. Similar to lighting device 200, lighting device 200a includes LED module 100 and light source controller 110. When lighting device 200a is a spotlight, LED module 100 including square substrate 1 as illustrated in FIG. 8 and FIG. 9 is used, for example.

### (Variations)

Although an LED module and lighting device according to the present invention have been described as above based on the above-described embodiment, the present invention is not limited to the above-described embodiment.

For example, the plurality of LED light sources included in LED module 100 may include seven or more types of LED light sources including one or more types of LED light sources in addition to the six types of LED light sources. Each set of the chromaticity coordinates of light emitted by the one or more types of LED light sources may be located in white region A0 or outside white region A0. Moreover, each of a region in a polygonal shape whose vertices are the chromaticity coordinates of light emitted by three or more types of LED light sources among the seven or more types of LED light sources and a region in a polygonal shape whose vertices are the chromaticity coordinates of light emitted by other three or more types of LED light sources among the seven or more types of LED light sources may cover the entirety of white region A0.

Furthermore, for example, although the six types of LED light sources include LED light sources that emit light in the same color in the above-described embodiment, the present invention is not limited to this example. The six types of LED light sources may emit light in mutually different colors.

Moreover, for example, although substrate 1 is in an elongated shape or square shape in the above-described embodiment, the present invention is not limited to this example. The shape of substrate 1 is not particularly limited, and substrate 1 in an arbitrary shape according to the type or the like of a lighting device in which LED module 100 is used can be used for LED module 100.

Furthermore, for example, although each set of the chromaticity coordinates of light emitted by the six types of LED light sources is located in a corresponding one of outermost regions among the regions defined by the general chromaticity classification according to the system color names in JIS Z8110 in the above-described embodiment, the present invention is not limited to this example. At least one set of the chromaticity coordinates of light emitted by the six types of LED light sources may be located in a region of an intermediate color between white region A0 and a corresponding one of the outermost regions among the regions defined by the general chromaticity classification according to the system color names in JIS Z8110.

In addition to the above, embodiments resulting from variations of the above-described embodiment conceivable by those skilled in the art, as well as embodiments resulting from arbitrary combinations of constituent elements and functions in the above-described embodiment are included in the present invention so long as they do not depart from the scope of the present invention.

Hereinafter, an LED module and lighting device according to the present invention described based on the above-described embodiment are exemplified. The LED module and lighting device according to the present invention are not limited to the examples below.

An LED module according to a first aspect of the present invention includes a substrate and a plurality of LED light sources that are mounted on the substrate and include six types of LED light sources that emit light having mutually different chromaticities. In an xy chromaticity diagram in an XYZ color system defined in JIS Z8701, each of a first region in a triangular shape whose vertices are chromaticity coordinates of light emitted by three types of LED light sources among the six types of LED light sources and a second region in a triangular shape whose vertices are chromaticity coordinates of light emitted by other three types of LED light sources among the six types of LED light sources covers all regions whose basic color names are white among regions defined by general chromaticity classification according to system color names in JIS Z8110.

An LED module according to a second aspect of the present invention is the LED module according to the first aspect. In the second aspect, in the xy chromaticity diagram, each set of chromaticity coordinates of light emitted by the six types of LED light sources is located in a corresponding one of outermost regions among the regions defined by the general chromaticity classification according to the system color names in JIS Z8110.

An LED module according to a third aspect of the present invention is the LED module according to the first or second aspect. In the third aspect, any one of the three types of LED light sources is placed next to each of other two of the three types of LED light sources, and any one of the other three types of LED light sources is placed next to each of other two of the other three types of LED light sources.

An LED module according to a fourth aspect of the present invention is the LED module according to any one of the first to third aspects. In the fourth aspect, the substrate is in an elongated shape, any one of the three types of LED light sources is placed on one end of the substrate in a lengthwise direction of the substrate, and among the other three types of LED light sources, an LED light source that emits light having chromaticity coordinates closest to chromaticity coordinates of light emitted by the one of the three types of LED light sources that is placed on the one end of the substrate is placed on an other end of the substrate in the lengthwise direction of the substrate.

An LED module according to a fifth aspect of the present invention is the LED module according to any one of the first to fourth aspects. In the fifth aspect, the substrate is in an elongated shape, and the plurality of LED light sources are arranged in two rows in the lengthwise direction of the substrate.

An LED module according to a sixth aspect of the present invention is the LED module according to any one of the first to fifth aspects. In the sixth aspect, the six types of LED light sources include: at least one LED light source from among a purple LED light source that emits purple light, a purple-blue LED light source that emits purple-blue light, and a blue LED light source that emits blue light; and a red LED light source that emits red light, and the red LED light source is not placed next to the at least one LED light source.

An LED module according to a seventh aspect of the present invention is the LED module according to any one of the first to sixth aspects. In the seventh aspect, at least one of the six types of LED light sources includes: an LED chip; and a phosphor that emits light when excited by light emitted by the LED chip.

An LED module according to an eighth aspect of the present invention is the LED module according to the seventh aspect. In the eighth aspect, the at least one of the six types of LED light sources that includes the LED chip and the phosphor emits yellow-red or green light.

An LED module according to a ninth aspect of the present invention is the LED module according to any one of the first to eighth aspects. In the ninth aspect, in the xy chromaticity diagram, at least one set of chromaticity coordinates of light emitted by the six types of LED light sources is located in each of a red region, a green region, a blue region, a yellow-red region, and a purple-blue region among the regions defined by the general chromaticity classification according to the system color names in JIS Z8110.

An LED module according to a tenth aspect of the present invention is the LED module according to any one of the first to ninth aspects. In the tenth aspect, in the xy chromaticity diagram, each set of chromaticity coordinates of 19 colors of POLY COLOUR color filters defined by Japan Association of Theatre and Entertainment Technology is covered by at least one of the first region or the second region.

A lighting device according to an eleventh aspect of the present invention includes the LED module according to any one of the first to tenth aspects.

Although the present invention has been described and illustrated in detail, it is clearly understood that the same is by way of example only and is not to be taken by way of limitation, the scope of the present invention being limited only by the terms of the appended claims.

### Reference Signs List

- 1: substrate
- 11: first LED light source
- 12: second LED light source
- 13: third LED light source
- 14: fourth LED light source
- 15: fifth LED light source
- 16: sixth LED light source
- 100: LED module
- 200, 200a: lighting device

## Claims

1. A light-emitting diode (LED) module comprising:
a substrate; and
a plurality of LED light sources that are mounted on the substrate and include six types of LED light sources that emit light having mutually different chromaticities, wherein
in an xy chromaticity diagram in an XYZ color system defined in Japanese Industrial Standards (JIS) Z8701, each of a first region in a triangular shape whose vertices are chromaticity coordinates of light emitted by three types of LED light sources among the six types of LED light sources and a second region in a triangular shape whose vertices are chromaticity coordinates of light emitted by other three types of LED light sources among the six types of LED light sources covers all regions whose basic color names are white among regions defined by general chromaticity classification according to system color names in JIS Z8110.

2. The LED module according to claim 1, wherein
in the xy chromaticity diagram, each set of chromaticity coordinates of light emitted by the six types of LED light sources is located in a corresponding one of outermost regions among the regions defined by the general chromaticity classification according to the system color names in JIS Z8110.

3. The LED module according to claim 1 or 2, wherein
any one of the three types of LED light sources is placed next to each of other two of the three types of LED light sources, and
any one of the other three types of LED light sources is placed next to each of other two of the other three types of LED light sources.

4. The LED module according to any one of claims 1 to 3, wherein
the substrate is in an elongated shape,
any one of the three types of LED light sources is placed on one end of the substrate in a lengthwise direction of the substrate, and
among the other three types of LED light sources, an LED light source that emits light having chromaticity coordinates closest to chromaticity coordinates of light emitted by the one of the three types of LED light sources that is placed on the one end of the substrate is placed on an other end of the substrate in the lengthwise direction of the substrate.

5. The LED module according to any one of claims 1 to 4, wherein
the substrate is in an elongated shape, and
the plurality of LED light sources are arranged in two rows in the lengthwise direction of the substrate.

6. The LED module according to any one of claims 1 to 5, wherein
the six types of LED light sources include:
at least one LED light source from among a purple LED light source that emits purple light, a purple-blue LED light source that emits purple-blue light, and a blue LED light source that emits blue light; and
a red LED light source that emits red light, and
the red LED light source is not placed next to the at least one LED light source.

7. The LED module according to any one of claims 1 to 6, wherein at least one of the six types of LED light sources includes:
an LED chip; and
a phosphor that emits light when excited by light emitted by the LED chip.

8. The LED module according to claim 7, wherein
the at least one of the six types of LED light sources that includes the LED chip and the phosphor emits yellow-red or green light.

9. The LED module according to any one of claims 1 to 8, wherein
in the xy chromaticity diagram, at least one set of chromaticity coordinates of light emitted by the six types of LED light sources is located in each of a red region, a green region, a blue region, a yellow-red region, and a purple-blue region among the regions defined by the general chromaticity classification according to the system color names in JIS Z8110.

10. The LED module according to any one of claims 1 to 9, wherein
in the xy chromaticity diagram, each set of chromaticity coordinates of 19 colors of POLY COLOUR color filters defined by Japan Association of Theatre and Entertainment Technology is covered by at least one of the first region or the second region.

11. A lighting device comprising:
the LED module according to any one of claims 1 to 10.
